# EUROPEAN PATENT SPECIFICATION

(11) **EP 3 166 002 B1**
(45) Date of publication and mention of the grant of the patent: **04.09.2019**
(21) Application number: 16197088.4
(22) Date of filing: 03.11.2016
(51) Int. Cl.: G06F 3/041, G06F 3/044, H03K 17/96

(54) **TERMINAL WITH TOUCH CONTROL BUTTON**
ENDGERÄT MIT BERÜHRUNGSSTEUERUNGSKNOPF
TERMINAL AVEC BOUTON DE COMMANDE TACTILE

(30) Priority: 05.11.2015 CN 201510744861
(43) Date of publication of application: 10.05.2017
(73) Proprietor: Xiaomi Inc., Beijing 100085 (CN)
(72) Inventor: JIANG, Zhongsheng, Haidian District, Beijing 100085 (CN); YANG, Kun, Haidian District, Beijing 100085 (CN); TAO, Jun, Haidian District, Beijing 100085 (CN)
(74) Representative: Grunert, Marcus

(56) References cited:
- WO-A1-2009/150285

## Description

### TECHNICAL FIELD

The present disclosure relates to a field of electronic technology, and more particularly to a terminal with a touch control button.

### BACKGROUND

With the development of electronic technology, a mobile terminal such as a cell phone is widely used and becomes a significant tool for communicating between people, and functions the terminal realizes become more and more abundant. Some functions of the terminal may be controlled by a button in the terminal, and there are generally three touch control buttons set below a screen, in which the touch control buttons are a menu button, a return button and a Home button (a button for returning to desktop) respectively, and functions corresponding to the touch control buttons are different.

There are at least following problems existing in the process of implementing the present disclosure.

Generally, an antenna for communication in the terminal is set along with the bottom edge of the terminal, and it is desired to leave a clearance zone of a certain size around the antenna. The efficiency of the antenna may be decreased if a semiconductor is set in the clearance zone. For a terminal with the antenna set in the bottom-side, the clearance zone is a bar zone lying a certain distance above the bottom edge. For the sake of beauty, a distance between the bottom edge of the terminal and the screen is reduced to the greatest extent when designing the terminal, such that the three touch control buttons in the terminal may locate in the clearance zone, which may lead to a lower efficiency of the antenna.

International Patent Application WO 2009/150285 A1 discloses a touch button false activation suppression. A touch member comprises a touch surface having at least two sensor electrodes that are separated from each other on the touch surface. Each of the sensor electrodes has a certain signal level threshold with relation to activate/lock the touch member. The touch surface is divided into a first area and a second area each comprising at least one of the sensor electrodes. Upon touching the touch member in an unlocked state, the at least two electrodes are arranged to measure periodically a signal level received from each of the electrodes to indicate a touch location, report periodically the touch location with respect to the first area of the touch surface, and report the measured signal level of each of the electrodes in the second area of the touch surface. The controller sends an instruction to select an operation state of the touch member based on calculated touch location information of the reported touch location and compared signal level information of the reported measured signal level.

### SUMMARY

In order to overcome problems existing in the related art, embodiments of the present invention provide a terminal with a touch control button according to claim 1. The technical solutions will be described as follows.

According to a first aspect of embodiments of the present invention, a terminal with a touch control button is provided. The terminal includes a processor and the touch control button,
in which:
the touch control button includes a touch control sensor and a button cover plate;
the processor is electrically connected to the touch control sensor;
the button cover plate is located above a sensor sheet of the touch control sensor; and
the processor is configured to acquire a detecting signal value of the touch control sensor, to determine a control instruction corresponding to the detecting signal value according to pre-stored corresponding relationships between detecting signal values and control instructions, and to execute the control instruction, in which the detecting signal value of the touch control sensor increases with an increase of a sensing area of the sensor sheet.

Further, the terminal includes one touch control button.

In this way, an area of a conductor in a clearance zone may be reduced, so that an influence on efficiency of an antenna may be reduced.

Further, the touch control sensor includes at least two sensor sheets, and the detecting signal value of the touch control sensor includes detecting signal values corresponding respectively to the at least two sensor sheets.

Further, the at least two sensor sheets are located on a same plane and are arranged in a surrounded structure from inside to outside, and are separated with each other, e.g. each sensor sheet has a circular or other geometric structure, the subsequent sensor sheet surrounding the previous one.

In this way, a probability of misoperation may be reduced.

Optionally, a distance between adjacent sensor sheets of the at least two sensor sheets is larger than a preset distance threshold.

In this way, a probability of misoperation may be reduced effectively.

Optionally, the touch control sensor includes three sensor sheets, in which the three sensor sheets are a first sensor sheet, a second sensor sheet and a third sensor sheet respectively;
the first sensor sheet, the second sensor sheet and the third sensor sheet are arranged from inside to outside in a surrounded structure sequentially, e.g. each sensor sheet has a circular or other geometric structure, the subsequent sensor sheet surrounding the previous one.

Optionally, the processor is configured to:
acquire the detecting signal value of the touch control sensor;
execute a preset first control instruction if the detecting signal value corresponding to the first sensor sheet of the touch control sensor is larger than a preset first threshold, the detecting signal value corresponding to the second sensor sheet of the touch control sensor is not larger than a preset second threshold, and the detecting signal value corresponding to the third sensor sheet of the touch control sensor is not larger than a preset third threshold;
execute a preset second control instruction if the detecting signal value corresponding to the first sensor sheet of the touch control sensor is larger than the preset first threshold, the detecting signal value corresponding to the second sensor sheet of the touch control sensor is larger than the preset second threshold, and the detecting signal value corresponding to the third sensor sheet of the touch control sensor is not larger than the preset third threshold; and
execute a preset third control instruction if the detecting signal value corresponding to the first sensor sheet of the touch control sensor is larger than the preset first threshold, the detecting signal value corresponding to the second sensor sheet of the touch control sensor is larger than the preset second threshold, and the detecting signal value corresponding to the third sensor sheet of the touch control sensor is larger than the preset third threshold.

In this way, a probability of misoperation may be reduced.

Further, according to the invention, the touch control sensor includes a preset number of sensor sheets;
the processor is configured to acquire the detecting signal value corresponding to each sensor sheet of the touch control sensor, to determine a number of continuously distributed sensor sheets beginning from an innermost sensor sheet in a surrounded structure and having corresponding detecting signal values larger than a fourth threshold, and to determine the control instruction corresponding to a number range the number falls into according to pre-stored corresponding relationships between number ranges and control instructions, and to execute the control instruction.

In this way, a probability of misoperation may be reduced.

Optionally, a shape of the sensor sheet of the at least two sensor sheets is a circular ring, a hollow rectangle or a hollow trapezoid.

Optionally, instructing icons are set on positions corresponding respectively to the at least two sensor sheets on the button cover plate.

In this way, a probability of misoperation may be reduced by promoting a user.

Optionally, parts of the button cover plate at the positions corresponding respectively to the at least two sensor sheets are transparent, and other parts of the button cover plate are nontransparent;
a light emitting diode is set between the at least two sensor sheets and the button cover plate.

In this way, a probability of misoperation may be reduced by promoting a user.

The technical solutions provided in embodiments of the presentinvention may have following advantageous effects.

In embodiments of the present invention, the terminal includes a processor and a touch control button, in which: the touch control button includes a touch control sensor and a button cover plate; the processor is electrically connected to the touch control sensor; the button cover plate is located above a sensor sheet of the touch control sensor; and the processor is configured to acquire a current detecting signal value of the touch control sensor, to determine a control instruction corresponding to the current detecting signal value according to pre-stored corresponding relationships between detecting signal values and control instructions, and to execute the control instruction, in which the detecting signal value of the touch control sensor increases with an increase of a sensing area of the sensor sheet. In this way, the terminal may realize more functions by using lesser touch control buttons, which means that the number of touch control buttons falling in the clearance zone may be lessened, so that the influence on efficiency of the antenna may be reduced.

It is to be understood that both the foregoing general description and the following detailed description are exemplary and explanatory only and are not restrictive of the disclosure.

### BRIEF DESCRIPTION OF THE DRAWINGS

Accompanying drawings herein are incorporated in and constitute a part of the specification, and illustrate example embodiments in line with the present disclosure, and serve to explain the principle of the present disclosure together with the description.
Fig. 1 is a schematic diagram of a terminal according to an example embodiment.
Fig. 2 is a schematic diagram of a touch control sensor according to an example embodiment.
Fig. 3(a) is a schematic diagram of a sensor sheet according to an example embodiment.
Fig. 3(b) is a schematic diagram of a sensor sheet according to an example embodiment.
Fig. 3(c) is a schematic diagram of a sensor sheet according to an example embodiment.
Fig. 4 is a schematic diagram of a terminal according to an example embodiment.

Embodiments of the present disclosure are illustrated in the above accompany drawings and will be described in further detail hereinafter. These accompany drawings and literal description are not intended to limit the scope of the idea of the present disclosure, but to explain the principle of the present disclosure with reference to particular embodiments for those skilled in the art.

**Reference numbers:**

| | |
|---|---|
| 1. processor | 2. touch control button |
| 21. touch control sensor | 22. button cover plate |
| 211. sensor sheet | 212. detection circuit |
| 2111. first sensor sheet | 2112. second sensor sheet |
| 2113. third sensor sheet | |

### DETAILED DESCRIPTION

Reference will now be made in detail to exemplary embodiments, examples of which are illustrated in the accompanying drawings. The following description refers to the accompanying drawings in which the same numbers in different drawings represent the same or similar elements unless otherwise represented. The implementations set forth in the following description of exemplary embodiments do not represent all implementations consistent with the disclosure. Instead, they are merely examples of apparatuses and methods consistent with aspects related to the disclosure as recited in the appended claims.

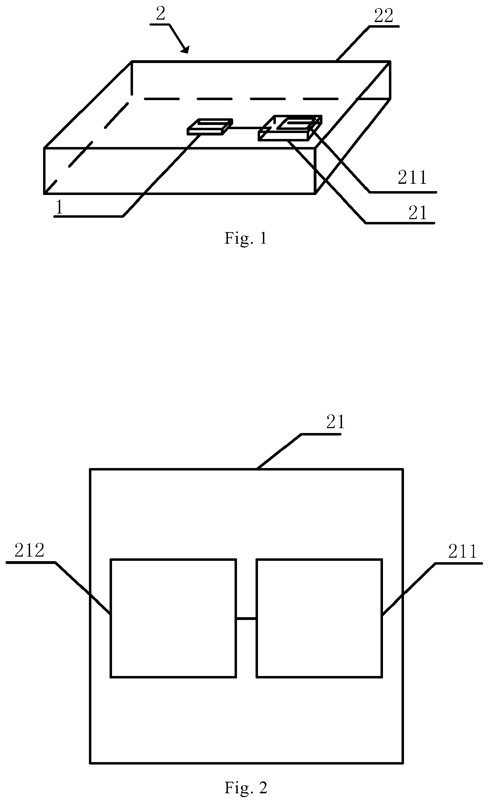

An embodiment of the present disclosure provides a terminal with a touch control button. As shown in Fig. 1, the terminal includes: a processor 1 and a touch control button 2, in which: the touch control button 2 includes a touch control sensor 21 and a button cover plate 22; the processor 1 is electrically connected to the touch control sensor 21; the button cover plate 22 is located above a sensor sheet 211 of the touch control sensor 21; and the processor 1 is configured to acquire a detecting signal value of the touch control sensor 21, to determine a control instruction corresponding to the detecting signal value according to pre-stored corresponding relationships between detecting signal values and control instructions, and to execute the control instruction corresponding to the detecting signal value, in which the detecting signal value of the touch control sensor 21 increases with an increase of a sensing area of the sensor sheet 211.

In the embodiment of the present disclosure, the terminal includes a processor and a touch control button, in which: the touch control button includes a touch control sensor and a button cover plate; the processor is electrically connected to the touch control sensor; the button cover plate is located above a sensor sheet of the touch control sensor; and the processor is configured to acquire a current detecting signal value of the touch control sensor, to determine a control instruction corresponding to the current detecting signal value according to pre-stored corresponding relationships between detecting signal values and control instructions, and to execute the control instruction, in which the detecting signal value of the touch control sensor increases with an increase of a sensing area of the sensor sheet. In this way, the terminal may realize more functions by using lesser touch control buttons, which means that the number of touch control buttons falling in the clearance zone may be lessened, so that the influence on efficiency of the antenna may be reduced.

Another embodiment of the present disclosure provides a terminal with a touch control button. As shown in Fig. 1, the terminal includes: a processor 1 and a touch control button 2, in which: the touch control button 2 includes a touch control sensor 21 and a button cover plate 22; the processor 1 is electrically connected to the touch control sensor 21; the button cover plate 22 is located above a sensor sheet 211 of the touch control sensor 21; and the processor 1 is configured to acquire a detecting signal value of the touch control sensor 21, to determine a control instruction corresponding to the detecting signal value according to pre-stored corresponding relationships between detecting signal values and control instructions, and to execute the control instruction corresponding to the detecting signal value, in which the detecting signal value of the touch control sensor 21 increases with an increase of a sensing area of the sensor sheet 211.

In this embodiment, the terminal may include the processor 1 and the touch control button 2, in which the touch control button 2 may be a capacitive touch control button, and may include the touch control sensor 21 and the button cover plate 22. If the button cover plate 22 is touched by a finger, the touch control sensor 21 may detect a detecting signal value which may be a capacitance value or a voltage signal value. The terminal also includes a screen including a screen cover plate and a displaying component, in which the screen cover plate is located above the displaying component, and the button cover plate 22 and the screen cover plate may be integrated together, or may be two respective parts of a same plate. As shown in Fig. 2, the touch control sensor may include a sensor sheet 211 and a detection circuit 212, in which the sensor sheet 211 may be a polar plate of a capacitor, the button cover plate 22 may be disposed above the sensor sheet 211 of the touch control sensor 21, and the sensor sheet 211 may sense a sensing area having a distance from the sensor sheet 211 within a preset distance threshold, which means that the capacitance value of the capacitor may be changed if the distance between the finger of the user and the sensor sheet 211 is within the preset distance threshold and the finger is approaching to the button cover plate 22. The larger the touching area between the finger and the button cover plate 22, the larger the capacitance value of the capacitor. The distance between the sensor sheet 211 and the button cover plate 22 may be set as the preset distance threshold, thus the sensing area of the sensor sheet is the touching area between the finger and the button cover plate 22.

The processor 1 may be electrically connected to the touch control sensor 21, and may acquire the detecting signal value from the touch control sensor 21, in which the detecting signal value may be a capacitance value of a capacitor or a voltage signal value. The voltage signal value may change with the capacitance value of the capacitor. The processor 1 may determine an executable control instruction according to the detecting signal value acquired from the touch control sensor 21, i.e., a function corresponding to the touch control button may be determined. Specifically, corresponding relationships between detecting signal values and control instructions may be pre-stored, and a control instruction corresponding to the detecting signal value may be determined in the corresponding relationships after the detecting signal value of the touch control sensor 21 is acquired, and the control instruction corresponding to the detecting signal value may be executed. The detecting signal value of the touch control sensor 21 increases with an increase of a sensing area of the sensor sheet 211, which means that the larger the touching area between the finger of the user and the button cover plate 22, the larger the detecting signal value of the touch control sensor 21, i.e., the function corresponding to the touch control button may varies with the sensing area of the sensor sheet.

Optionally, the terminal includes one touch control button.

Thus, the area of the conductor in the clearance zone may be reduced, so that an influence on efficiency of the antenna may be reduced.

Optionally, the touch control sensor 21 includes at least two sensor sheets, and the detecting signal value of the touch control sensor 21 includes detecting signal values corresponding respectively to the at least two sensor sheets.

In this embodiment, the touch control sensor 21 may include at least two sensor sheets, which means that the detection circuit 212 of the touch control sensor 21 may detect the detecting signal values corresponding respectively to the at least two sensor sheets.

Optionally, the at least two sensor sheets are located on a same plane and are arranged in a surrounded structure from inside to outside, and are separated with each other.

In this embodiment, the at least two sensor sheets of the touch control sensor 21 are located on a same plane, and are arranged in a surrounded structure, i.e. a subsequent sensor sheet surrounding a previous one, from inside to outside, and are separated in a certain distance with each other. When distributing the at least two sensor sheets included in the touch control sensor 21, one of the at least two sensor sheets is arranged at a center position, the other sensor sheets are arranged sequentially in a manner that multiple sensor sheets correspond to or share a same center. Thus, a misoperation may be avoided.

Optionally, a distance between adjacent sensor sheets of the at least two sensor sheets is larger than a preset distance threshold.

In this embodiment, the at least two sensor sheets are arranged in a surrounded structure from inside to outside, and the distance between adjacent sensor sheets of the at least two sensor sheets is larger than the preset distance threshold. Thus, a probability of misoperation may be reduced effectively.

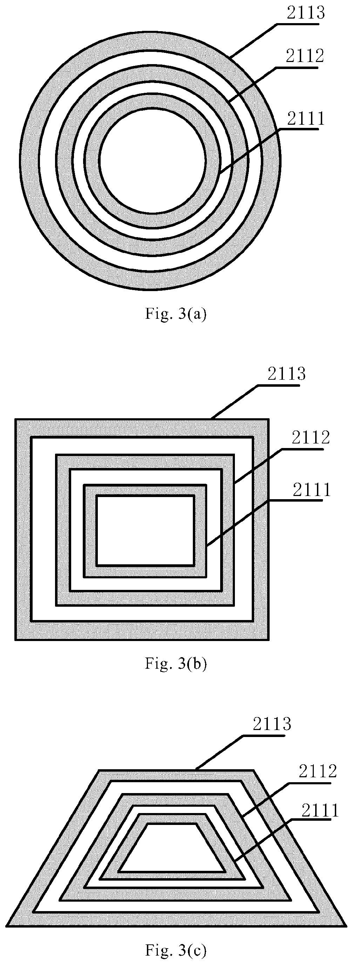

Optionally, the touch control sensor 21 includes three sensor sheets, in which the three sensor sheets are a first sensor sheet 2111, a second sensor sheet 2112 and a third sensor sheet 2113 respectively; the first sensor sheet 2111, the second sensor sheet 2112 and the third sensor sheet 2113 are arranged sequentially from inside to outside in a surrounded structure, i.e. a subsequent sensor sheet surrounding a previous one
In this embodiment, the touch control sensor 21 includes three sensor sheets, in which the three sensor sheets are the first sensor sheet 2111, the second sensor sheet 2112 and the third sensor sheet 2113 respectively. A shape of the sensor sheet may be a circular ring as shown in Fig. 3 (a), the shape of the sensor sheet may be a hollow rectangle as shown in Fig. 3 (b), or the shape of the sensor sheet may be a hollow trapezoid as shown in Fig. 3 (c). The shape of each sensor sheet of the touch control sensor 21 may be a closed ring, and the shape of a sensor sheet other than the innermost sensor sheet in the surrounded structure may have an opening (i.e., not closed ring), so that the innermost sensor sheet in the surrounded structure may electrically connected to the detection circuit 212 via wires, which means that it is convenient for the innermost sensor sheet to be electrically connected to the detection circuit 212 if the sensor sheets are located on a same plane with the detection circuit 212. The three sensor sheets are electrically connected with the detection circuit 212, and the detecting signal value of the touch control sensor 21 includes detecting signal values corresponding respectively to the three sensor sheets, which means that the detection circuit 212 of the touch control sensor 21 may detect the detecting signal value corresponding to each sensor sheet. The three sensor sheets are arranged sequentially from inside to outside in a surrounded structure, in which the first sensor sheet 2111 is arranged in the center, the second sensor sheet 2112 and the third sensor sheet 2113 are arranged sequentially from inside to outside.

Optionally, the processor 1 is configured to acquire the detecting signal value of the touch control sensor 21; and to execute a preset first control instruction if the detecting signal value corresponding to the first sensor sheet 2111 of the touch control sensor 21 is larger than a preset first threshold, the detecting signal value corresponding to the second sensor sheet 2112 of the touch control sensor 21 is not larger than a preset second threshold, and the detecting signal value corresponding to the third sensor sheet 2113 of the touch control sensor 21 is not larger than a preset third threshold; to execute a preset second control instruction if the detecting signal value corresponding to the first sensor sheet 2111 of the touch control sensor 21 is larger than a preset first threshold, the detecting signal value corresponding to the second sensor sheet 2112 of the touch control sensor 21 is larger than a preset second threshold, and the detecting signal value corresponding to the third sensor sheet 2113 of the touch control sensor 21 is not larger than a preset third threshold; and to execute a preset third control instruction if the detecting signal value corresponding to the first sensor sheet 2111 of the touch control sensor 21 is larger than a preset first threshold, the detecting signal value corresponding to the second sensor sheet 2112 of the touch control sensor 21is larger than a preset second threshold, and the detecting signal value corresponding to the third sensor sheet 2113 of the touch control sensor 21 is larger than a preset third threshold.

In this embodiment, the processor 1 is configured to acquire the detecting signal value of the touch control sensor 21, in which the detecting signal value may be the detecting signal values corresponding respectively to the first sensor sheet, the second sensor sheet and the third sensor sheet. It is judged whether the detecting signal value corresponding to each sensor sheet reaches a corresponding preset threshold after acquiring the current detecting signal value, i.e., to determine the control instruction corresponding to the current detecting signal value. Specifically, a first threshold, a second threshold, a third threshold and corresponding relationships between detecting signal values (including detecting signal value corresponding to each sensor sheet) and control instructions may be pre-stored, and the control instruction to be executed may be determined according to the corresponding relationships, which means that the preset first control instruction may be executed if the detecting signal value corresponding to the first sensor sheet 2111 of the touch control sensor 21 is larger than the preset first threshold, the detecting signal value corresponding to the second sensor sheet 2112 of the touch control sensor 21 is not larger than the preset second threshold, and the detecting signal value corresponding to the third sensor sheet 2113 of the touch control sensor 21 is not larger than the preset third threshold; the preset second control instruction may be executed if the detecting signal value corresponding to the first sensor sheet 2111 of the touch control sensor 21 is larger than the preset first threshold, the detecting signal value corresponding to the second sensor sheet 2112 of the touch control sensor 21 is larger than the preset second threshold, and the detecting signal value corresponding to the third sensor sheet 2113 of the touch control sensor 21 is not larger than the preset third threshold; and the preset third control instruction may be executed if the detecting signal value corresponding to the first sensor sheet 2111 of the touch control sensor 21 is larger than the preset first threshold, the detecting signal value corresponding to the second sensor sheet 2112 of the touch control sensor 21 is larger than the preset second threshold, and the detecting signal value corresponding to the third sensor sheet 2113 of the touch control sensor 21 is larger than the preset third threshold. The preset first threshold, the preset second threshold and the preset third threshold may be a same value, or may be different values, or may be set according to the sensing area of the corresponding sensor sheet. For example, for a sensor sheet with larger area, the corresponding threshold of the detecting signal value of the touch control sensor is larger. Thus, a probability of misoperation may be reduced.

Optionally, the touch control sensor includes a preset number of sensor sheets; the processor is configured to acquire the detecting signal value corresponding to each sensor sheet of the touch control sensor 21; the processor is configured to determine, in the sensor sheets of the touch control sensor 21, the number of continuously distributed sensor sheets beginning from an innermost sensor sheet in a surrounded structure and having detecting signal values larger than a fourth threshold; the processor is configured to determine the control instruction corresponding to a number range the number falls into according to pre-stored corresponding relationships between number ranges and control instructions, and to execute the control instruction.

In this embodiment, the touch control sensor may include a plurality of sensor sheets, in which the number of the plurality of sensor sheets may be more than the number of functions the touch control button 2 may realize. The processor 1 may acquire the detecting signal value corresponding to each sensor sheet of the touch control sensor 21, and determine a number of continuously distributed sensor sheets beginning from an innermost sensor sheet in a surrounded structure and having corresponding detecting signal values larger than a fourth threshold. For example, the touch control sensor 21 may include thirty sensor sheets, and may realize three functions, the innermost sensor sheet is the first sensor sheet, the remaining sensor sheets are arranged sequentially from inside to outside, in which the outermost sensor sheet is the thirtieth sensor sheet. The processor may acquire the detecting signal value corresponding to each of the thirty sensor sheets, and determine the magnitude relation between each detecting signal value acquired and the fourth threshold, and determine the number of continuously distributed sensor sheets which are arranged sequentially from inside to outside and have corresponding detecting signal values larger than the fourth threshold (for example, if the detecting signal values corresponding to the first sensor sheet, the second sensor sheet, the third sensor sheet and the fifth sensor sheet are larger than the fourth threshold and the detecting signal value corresponding to the fourth sensor sheet is not larger than the fourth threshold, then it is determined that the number of the continuously distributed sensor sheets is three). After the number of the sensor sheets is determined, the processor may determine the number range which the number falls into included in the pre-stored corresponding relationships, and acquire the number range including the number and determine the control instruction corresponding to the number range according to the pre-stored corresponding relationships between number ranges and control instructions, and execute the control instruction. Thus, a probability of misoperation may be reduced.

Optionally, instructing icons are set on positions corresponding respectively to the at least two sensor sheets on the button cover plate 22.

In this embodiment, an instructing icon is set on a position corresponding to each sensor sheet on the button cover plate 22. Thus, a probability of misoperation may be reduced by promoting a user.

Optionally, parts of the button cover plate 22 at the positions corresponding respectively to the at least two sensor sheets are transparent, and other parts of the button cover plate are nontransparent; and a light emitting diode is set between the at least two sensor sheets and the button cover plate.

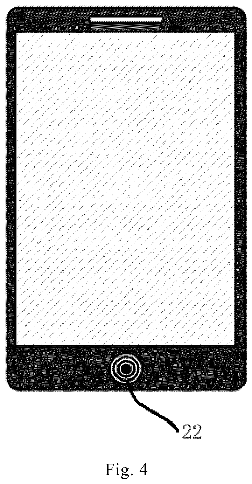

In this embodiment, as shown in Fig. 4, the part on the back side of the button cover plate and at a position other than the position corresponding to each sensor sheet is painted with a dark material, such as graphite, such that the part at the position corresponding to each sensor sheet is transparent. A light emitting diode is set between a sensor sheet and the button cover plate, thus the position corresponding to each sensor sheet on the button cover plate 22 is in a lighting state, or, the position corresponding to each sensor sheet is in a lighting state when the terminal is working. Thus, a probability of misoperation may be reduced by promoting a user.

In the embodiments of the present invention, the terminal includes a processor and a touch control button, in which: the touch control button includes a touch control sensor and a button cover plate; the processor is electrically connected to the touch control sensor; the button cover plate is located above a sensor sheet of the touch control sensor; and the processor is configured to acquire a current detecting signal value of the touch control sensor, to determine a control instruction corresponding to the current detecting signal value according to pre-stored corresponding relationships between detecting signal values and control instructions, and to execute the control instruction, in which the detecting signal value of the touch control sensor increases with an increase of a sensing area of the sensor sheet. Thus, the terminal may realize more functions by using lesser touch control buttons, which means that the number of touch control buttons falling in the clearance zone may be lessened, so that the influence on efficiency of the antenna may be reduced.

## Claims

1. A terminal, comprising a processor (1) and a touch control button (2), wherein
the touch control button (2) comprises a touch control sensor (21) and a button cover plate (22);
the processor (1) is electrically connected to the touch control sensor (21);
the button cover plate (22) is located above a sensor sheet (211) of the touch control sensor (21);
the processor (1) is configured to acquire a detecting signal value of the touch control sensor (21), to determine a control instruction corresponding to the detecting signal value according to pre-stored corresponding relationships between detecting signal values and control instructions, and to execute the control instruction, wherein the detecting signal value of the touch control sensor (21) increases with an increase of a sensing area of the sensor sheet (211), and a function of the touch control button (2) varies with the sensing area of the sensor sheet (211);
wherein the terminal comprises one touch control button (2);
wherein the touch control sensor (21) comprises at least two sensor sheets (211), and the detecting signal value of the touch control sensor (21) comprises detecting signal values corresponding respectively to the at least two sensor sheets (211);
wherein the at least two sensor sheets (211) are located on a same plane and are arranged in a surrounded structure from inside to outside, and are separated with each other; and
wherein the touch control sensor (21) comprises a preset number of sensor sheets (211);
the processor (1) is configured to acquire the detecting signal value corresponding to each sensor sheet (211) of the touch control sensor (21), to determine a number of continuously distributed sensor sheets (211) beginning from an innermost sensor sheet (211) in a surrounded structure and having corresponding detecting signal values larger than a pre-set threshold, and to determine the control instruction corresponding to a number range the number falls into according to pre-stored corresponding relationships between number ranges and control instructions, and to execute the control instruction.

2. The terminal according to claim 1, wherein a distance between adjacent sensor sheets of the at least two sensor sheets (211) is larger than a preset distance threshold.

3. The terminal according to claim 1, the touch control sensor (21) comprises three sensor sheets (211), wherein the three sensor sheets (211) are a first sensor sheet (2111), a second sensor sheet (2112) and a third sensor sheet (2113) respectively;
the first sensor sheet (2111), the second sensor sheet (2112) and the third sensor sheet (2113) are arranged from inside to outside in a surrounded structure sequentially.

4. The terminal according to claim 3, wherein the processor (1) is configured to:
execute a preset first control instruction if the detecting signal value corresponding to the first sensor sheet (2111) of the touch control sensor (21) is larger than a preset first threshold, the detecting signal value corresponding to the second sensor sheet (2112) of the touch control sensor (21) is not larger than a preset second threshold, and the detecting signal value corresponding to the third sensor sheet (2113) of the touch control sensor (21) is not larger than a preset third threshold;
execute a preset second control instruction if the detecting signal value corresponding to the first sensor sheet (2111) of the touch control sensor (21) is larger than the preset first threshold, the detecting signal value corresponding to the second sensor sheet (2112) of the touch control sensor (21) is larger than the preset second threshold, and the detecting signal value corresponding to the third sensor sheet (2113) of the touch control sensor (21) is not larger than the preset third threshold; and
execute a preset third control instruction if the detecting signal value corresponding to the first sensor sheet (2111) of the touch control sensor (21) is larger than the preset first threshold, the detecting signal value corresponding to the second sensor sheet (2112) of the touch control sensor (21) is larger than the preset second threshold, and the detecting signal value corresponding to the third sensor sheet (2113) of the touch control sensor (21) is larger than the preset third threshold.

5. The terminal according to claim 1, wherein a shape of the sensor sheet (211) of the at least two sensor sheets (211) is a circular ring, a hollow rectangle or a hollow trapezoid.

6. The terminal according to claim 1, wherein instructing icons are set on positions corresponding respectively to the at least two sensor sheets (211) on the button cover plate (22).

7. The terminal according to claim 1, wherein parts of the button cover plate (22) at the positions corresponding respectively to the at least two sensor sheets (211) are transparent, and other parts of the button cover plate (22) are nontransparent;
a light emitting diode is set between the at least two sensor sheets (211) and the button cover plate (22).

## Patentansprüche

1. Terminal bzw. Endgerät, umfassend einen Prozessor (1) und eine Berührungssteuerungstaste (2), wobei die Berührungssteuerungstaste (2) einen Berührungssteuerungssensor (21) und eine Tastenabdeckplatte (22) umfasst;
der Prozessor (1) elektrisch mit dem Berührungssteuerungssensor (21) verbunden ist;
die Tastenabdeckplatte (22) über einer Sensorplatte bzw. einem Sensorblech (211) des Berührungssteuerungssensors (21) angeordnet ist;
der Prozessor (1) eingerichtet ist, einen Detektionssignalwert des Berührungssteuerungssensors (21) zu erfassen, um eine dem Detektionssignalwert entsprechende Steuerungsanweisung gemäß vorab gespeicherten entsprechenden Beziehungen zwischen Detektionssignalwerten und Steuerungsanweisungen zu bestimmen und um die Steuerungsanweisung auszuführen, wobei der Detektionssignalwert des Berührungssteuerungssensors (21) mit einer Erhöhung eines Abtastbereichs der Sensorplatte (211) zunimmt und eine Funktion der Berührungssteuerungstaste (2) mit dem Abtastbereich der Sensorplatte (211) variiert;
wobei das Endgerät eine Berührungssteuerungstaste (2) umfasst;
wobei der Berührungssteuerungssensor (21) mindestens zwei Sensorplatten (211) umfasst, und der Detektionssignalwert des Berührungssteuerungssensors (21) Detektionssignalwerte umfasst, die jeweils den mindestens zwei Sensorplatten (211) entsprechen;
wobei die mindestens zwei Sensorplatten (211) auf einer gleichen Ebene angeordnet sind und in einer umgebenden Struktur von innen nach außen angeordnet sind und voneinander getrennt sind; und
wobei der Berührungssteuerungssensor (21) eine voreingestellte Anzahl von Sensorplatten (211) umfasst;
wobei der Prozessor (1) eingerichtet ist, den Detektionssignalwert entsprechend jeder Sensorplatte (211) des Berührungssteuerungssensors (21) zu erhalten, um eine Anzahl von kontinuierlich verteilten Sensorplatten (211) zu bestimmen, die beginnend von einer innersten Sensorplatte (211) in einer umgebenden Struktur ausgehen und entsprechende Detektionssignalwerte aufweisen, die größer sind als ein voreingestellter Schwellenwert, und um die Steuerungsanweisung zu bestimmen, die einem Zahlenbereich entspricht, in den die Nummer fällt, entsprechend den zuvor gespeicherten entsprechenden Beziehungen zwischen Zahlenbereichen und Steuerungsanweisungen, und um die Steuerungsanweisung auszuführen.

2. Endgerät nach Anspruch 1, wobei ein Abstand zwischen benachbarten Sensorplatten der mindestens zwei Sensorplatten (211) größer ist als ein vorgegebener Entfernungsschwellenwert.

3. Endgerät nach Anspruch 1, wobei der Berührungssteuerungssensor (21) drei Sensorplatten (211) umfasst, wobei die drei Sensorplatten (211) jeweils eine erste Sensorplatte (2111), eine zweite Sensorplatte (2112) und eine dritte Sensorplatte (2113) sind;
wobei die erste Sensorplatte (2111), die zweite Sensorplatte (2112) und die dritte Sensorplatte (2113) von innen nach außen in einer umgebenden Struktur nacheinander angeordnet sind.

4. Endgerät nach Anspruch 3, wobei der Prozessor (1) eingerichtet ist, um:
eine voreingestellte erste Steuerungsanweisung ausführen, wenn der der ersten Sensorplatte (2111) des Berührungssteuerungssensors (21) entsprechende Detektionssignalwert größer ist als ein voreingestellter erster Schwellenwert, der der zweiten Sensorplatte (2112) des Berührungssteuerungssensors (21) entsprechende Detektionssignalwert nicht größer ist als ein voreingestellter zweiter Schwellenwert, und der der dritten Sensorplatte (2113) des Berührungssteuerungssensors (21) entsprechende Detektionssignalwert nicht größer ist als ein voreingestellter dritter Schwellenwert;
eine voreingestellte zweite Steuerungsanweisung auszuführen, wenn der der ersten Sensorplatte (2111) des Berührungssteuerungssensors (21) entsprechende Detektionssignalwert größer ist als der voreingestellte erste Schwellenwert, der der zweiten Sensorplatte (2112) des Berührungssteuerungssensors (21) entsprechende Detektionssignalwert größer ist als der voreingestellte zweite Schwellenwert, und der der dritten Sensorplatte (2113) des Berührungssteuerungssensors (21) entsprechende Detektionssignalwert nicht größer ist als der voreingestellte dritte Schwellenwert; und
eine voreingestellte dritte Steuerungsanweisung ausführen, wenn der der ersten Sensorplatte (2111) des Berührungssteuerungssensors (21) entsprechende Detektionssignalwert größer ist als der voreingestellte erste Schwellenwert, der der zweiten Sensorplatte (2112) des Berührungssteuerungssensors (21) entsprechende Detektionssignalwert größer ist als der voreingestellte zweite Schwellenwert, und der der dritten Sensorplatte (2113) des Berührungssteuerungssensors (21) entsprechende Detektionssignalwert größer ist als der voreingestellte dritte Schwellenwert.

5. Endgerät nach Anspruch 1, wobei eine Form der Sensorplatte (211) der mindestens zwei Sensorplatten (211) ein kreisförmiger Ring, ein hohles Rechteck oder ein hohles Trapez ist.

6. Endgerät nach Anspruch 1, wobei Anweisungssymbole auf Positionen entsprechend den mindestens zwei Sensorplatten (211) auf der Tastenabdeckplatte (22) eingestellt sind.

7. Endgerät nach Anspruch 1, wobei Abschnitte der Tastenabdeckplatte (22) an den Positionen, die jeweils den mindestens zwei Sensorplatten (211) entsprechen, transparent sind und andere Abschnitte der Tastenabdeckplatte (22) intransparent sind;
wobei zwischen den mindestens zwei Sensorplatten (211) und der Tastenabdeckplatte (22) eine lichtemittierende Diode angeordnet ist.

## Revendications

1. Terminal, comprenant un processeur (1) et un bouton de commande tactile (2), dans lequel
le bouton de commande tactile (2) comprend un capteur de commande tactile (21) et une plaque de recouvrement de bouton (22) ;
le processeur (1) est connecté électriquement au capteur de commande tactile (21) ;
la plaque de recouvrement de bouton (22) est située au-dessus d'une feuille de capteur (211) du capteur de commande tactile (21) ;
le processeur (1) est configuré pour acquérir une valeur de signal de détection du capteur de commande tactile (21), pour déterminer une instruction de commande correspondant à la valeur de signal de détection selon des relations correspondantes préenregistrées entre des valeurs de signal de détection et des instructions de commande, et pour exécuter l'instruction de commande, dans lequel la valeur de signal de détection du capteur de commande tactile (21) augmente avec une augmentation de la surface sensible de la feuille (211) du capteur et une fonction de la touche tactile (2) varie avec la surface sensible de la feuille (211) du capteur ;
dans laquelle le terminal comprend un bouton de commande tactile (2) ;
dans laquelle le capteur de commande tactile (21) comprend au moins deux feuilles de capteur (211), et la valeur de signal de détection du capteur de commande tactile (21) comprend la détection de valeurs de signal correspondant respectivement aux au moins deux feuilles de capteur (211) ;
dans laquelle les au moins deux feuilles de capteur (211) sont situées sur un même plan et sont disposées dans une structure entourée de l'intérieur vers l'extérieur, et sont séparées les unes des autres ; et
dans laquelle le capteur de commande tactile (21) comprend un nombre prédéfini de feuilles de capteur (211) ;
le processeur (1) est configuré pour acquérir la valeur de signal de détection correspondant à chaque feuille de capteur (211) du capteur de commande tactile (21), pour déterminer un nombre de feuilles de capteur (211) réparties en continu à partir d'une feuille de capteur la plus interne (211) dans une structure entourée et ayant des valeurs de signal de détection correspondantes supérieures à un seuil prédéfini, et pour déterminer l'instruction de commande correspondant à une plage de nombres dans laquelle le nombre tombe selon des relations correspondantes mémorisées au préalable entre les plages de nombres et les instructions de commande et pour exécuter l'instruction de commande.

2. Terminal selon la revendication 1, dans lequel une distance entre des feuilles de capteurs adjacentes des au moins deux feuilles de capteurs (211) est supérieure à un seuil de distance prédéfini.

3. Terminal selon la revendication 1, le capteur de commande tactile (21) comprend trois feuilles de capteurs (211), les trois feuilles de capteurs (211) étant respectivement une première feuille de capteurs (2111), une deuxième feuille de capteurs (2112) et une troisième feuille de capteurs (2113) ;
la première feuille de capteur (2111), la deuxième feuille de capteur (2112) et la troisième feuille de capteur (2113) sont disposées séquentiellement de l'intérieur vers l'extérieur dans une structure entourée.

4. Terminal selon la revendication 3, dans lequel le processeur (1) est configuré pour :
exécuter une première instruction de commande préréglée si la valeur du signal de détection correspondant à la première feuille de capteur (2111) du capteur de commande tactile (21) est supérieure à un premier seuil préréglé, la valeur du signal de détection correspondant à la deuxième feuille de capteur (2112) du capteur de commande tactile (21) est inférieure à un deuxième seuil préréglé, et la valeur du signal de détection correspondant à la troisième feuille de capteur (2113) du capteur de commande tactile (21) est supérieure à un troisième seuil préréglé ;
exécuter une deuxième instruction de commande préréglée si la valeur du signal de détection correspondant à la première feuille de capteur (2111) du capteur de commande tactile (21) est supérieure au premier seuil préréglé, la valeur du signal de détection correspondant à la deuxième feuille de capteur (2112) du capteur de commande tactile (21) est supérieure au deuxième seuil préréglé et la valeur du signal de détection correspondant à la troisième feuille de capteur (2113) du capteur de commande tactile (21) est inférieure au troisième seuil préréglé ; et
exécuter une troisième instruction de commande préréglée si la valeur du signal de détection correspondant à la première feuille de capteur (2111) du capteur de commande tactile (21) est supérieure au premier seuil préréglé, la valeur du signal de détection correspondant à la deuxième feuille de capteur (2112) du capteur de commande tactile (21) est supérieure au deuxième seuil préréglé et la valeur de signal de détection correspondant à la troisième feuille de capteur (2113) du capteur de commande tactile (21) est supérieure au troisième seuil préréglé.

5. Terminal selon la revendication 1, dans lequel une forme de la feuille de capteur (211) des au moins deux feuilles de capteur (211) est une bague circulaire, un rectangle creux ou un trapèze creux.

6. Terminal selon la revendication 1, dans lequel des icônes d'instruction sont placées sur des positions correspondant respectivement aux au moins deux feuilles de capteurs (211) sur la plaque de recouvrement de bouton (22).

7. Terminal selon la revendication 1, dans lequel des parties de la plaque de recouvrement de bouton (22) aux positions correspondant respectivement aux au moins deux feuilles de capteur (211) sont transparentes, et d'autres parties de la plaque de recouvrement de bouton (22) ne sont pas transparentes ;
une diode électroluminescente est placée entre les au moins deux feuilles de capteur (211) et la plaque de recouvrement de bouton (22).
